# EUROPEAN PATENT APPLICATION

(11) **EP 4 825 206 A1**
(43) Date of publication of application: **21.10.2026**
(21) Application number: 23961423.3
(22) Date of filing: 13.12.2023
(51) Int. Cl.: A24F 40/40

(54) **FLAVOR INHALER AND METHOD FOR MANUFACTURING FLAVOR INHALER**

(71) Applicant: Japan Tobacco Inc., Tokyo 105-6927 (JP)
(72) Inventor: ICHINOSE, Atsushi, Tokyo 130-8603 (JP); INOUE, Isamu, Tokyo 130-8603 (JP)
(74) Representative: Hoffmann Eitle
(86) International application number: PCT/JP2023/044578
(87) International publication number: WO 2025/126356

(57) **Abstract**

This flavor inhaler comprises: a battery having a battery tab; a flexible printed circuit board having a soldering portion that is soldered to the battery tab and that is disposed so as to at least partially overlap the battery; and a heat insulating member and/or a heat diffusing member disposed between the flexible printed circuit board and the battery.

## Description

### TECHNICAL FIELD

The present invention relates to a flavor inhaler and a method for manufacturing a flavor inhaler.

### BACKGROUND ART

Heat-not-burn flavor inhalers, which heat a material comprising a flavor source to generate an aerosol, etc. without burning the material, are conventionally known. Known flavor inhalers of this type include a heating portion for heating a flavor generating article, a battery for supplying power to the heating portion, and a control circuit (see, for example, PTL 1).

### CITATION LIST

### PATENT LITERATURE

PTL 1: JP 6737902 B2

### SUMMARY OF INVENTION

### TECHNICAL PROBLEM

In such a flavor inhaler, a circuit may be soldered to battery tabs of the battery in order to connect the battery and the circuit. At this time, the soldering temperature may exceed 230°C, for example. As a result, with a positional relationship in which the battery and the circuit at least partially overlap, the heat generated during soldering may adversely affect the battery.

One objective of the present invention lies in inhibiting the heat generated by soldering from adversely affect the battery.

### SOLUTION TO PROBLEM

According to a first aspect, a flavor inhaler is provided. The flavor inhaler comprises: a battery having a battery tab; a flexible printed circuit board having a soldering portion that is soldered to the battery tab and that is disposed so as to at least partially overlap the battery; and a heat insulating member and/or a heat diffusing member disposed between the flexible printed circuit board and the battery.

According to the first aspect, the heat insulating member and/or the heat diffusing member can inhibit the transfer of heat generated at the soldering portion to the battery, or the localized transfer of this heat to the battery, thereby making it possible to inhibit the heat generated by soldering from adversely affecting the battery.

The heat insulating member and/or the heat diffusing member may be disposed between the soldering portion and the battery.

The soldering portion becomes hotter than other parts of the flexible printed circuit board when being soldered to the battery tab. Therefore, by disposing the heat insulating member and/or the heat diffusing member between the soldering portion and the battery, the transfer of heat generated at the soldering portion can be efficiently inhibited.

The heat insulating member or the heat diffusing member may be in direct or indirect contact with the flexible printed circuit board and the battery.

In this case, it is possible to inhibit the formation of gaps between the heat insulating member or heat diffusing member and the flexible printed circuit board and battery, thereby making it possible to inhibit deformation of the flexible printed circuit board as a result of the flexible printed circuit board being pressed by the soldering iron during soldering of the battery tab and the soldering portion. In addition, the flavor inhaler can be made compact.

The flavor inhaler may include the heat insulating member and the heat diffusing member, the heat diffusing member may be disposed closer to the battery than the heat insulating member, and the heat insulating member may be disposed closer to the flexible printed circuit board than the heat diffusing member.

In this case, heat transfer can be inhibited by means of the heat insulating member located relatively close to the soldering portion of the flexible printed circuit board, and heat from the heat insulating member can be diffused by means of the heat diffusing member located relatively close to the battery. Therefore, the heat insulating member and the heat diffusing member can efficiently inhibit the transfer of heat generated at the soldering portion.

The flexible printed circuit board may have a first surface on which the soldering portion is provided and a second surface facing the heat insulating member and/or the heat diffusing member.

If the soldering portion were provided on the second surface, it would be necessary to dispose the heat insulating member and/or the heat diffusing member between the flexible printed circuit board and the battery after the battery tab and the soldering portion have been soldered. However, when the soldering portion is provided on the first surface, soldering of the soldering portion on the first surface can be performed after assembly with the battery such that the second surface of the flexible printed circuit board faces the heat insulating member and/or the heat diffusing member. The assembly and soldering of the battery, the heat insulating member and/or the heat diffusing member, and the flexible printed circuit board can therefore be made easier than in a case in which the soldering portion is provided on the second surface.

The flavor inhaler may have a heating portion configured to heat a flavor generating article and a circuit board configured to control heating of the heating portion, and the flexible printed circuit board may be connected to the circuit board.

In this case, the battery can supply power to the circuit board and the heating portion via the flexible printed circuit board to appropriately heat the flavor generating article.

The heating portion may be disposed adjacent to the battery in a longitudinal direction, and the circuit board may be disposed adjacent to the flexible printed circuit board in the longitudinal direction and adjacent to the heating portion in a direction perpendicular to the longitudinal direction.

In this case, the flavor inhaler can be made smaller since the heating portion and the circuit board are disposed adjacent to the battery and the flexible printed circuit board in the longitudinal direction and the battery tab and the flexible printed circuit board are soldered together at the soldering portion.

The distance between the soldering portion and the battery may be 1.5 mm or less.

In this case, although heat generated during soldering is transferred readily to the battery because the soldering portion and the battery are close to one another, the heat insulating member and/or the heat diffusing member can inhibit transfer of the heat generated at the soldering portion to the battery, or the localized transfer of this heat to the battery.

The heat insulating member may comprise nylon or Nomex.

In this case, the heat insulating member can be configured using an inexpensive and readily available material.

The heat diffusing member may comprise a graphite sheet.

In this case, the heat diffusing member can be configured using an inexpensive and readily available material.

According to a second aspect, a method for manufacturing a flavor inhaler is provided. The manufacturing method includes: a first step for disposing a heat insulating member and/or a heat diffusing member between a battery and a flexible printed circuit board; and a second step, after the first step, for soldering a battery tab of the battery and the flexible printed circuit board together.

In this case, the heat insulating member and/or the heat diffusing member can inhibit the transfer of heat generated by the soldering in the second step to the battery, or the localized transfer of this heat to the battery, thereby making it possible to inhibit the heat generated by the soldering from adversely affecting the battery.

The manufacturing method may include, after the second step, a step for removing the heat insulating member and/or the heat diffusing member from between the battery and the flexible printed circuit board.

In this case, the heat insulating member and/or the heat diffusing member can be reused in the manufacture of other flavor inhalers, thereby making it possible to inhibit an increase in the manufacturing costs.

### BRIEF DESCRIPTION OF DRAWINGS

Fig. 1 is an oblique view showing a flavor generating system according to an embodiment of the present invention.
Fig. 2 is an oblique view showing a flavor inhaler according to an embodiment of the present invention.
Fig. 3 is a cross-sectional view showing the flavor inhaler as viewed in the direction of the arrows 3-3 shown in fig. 2.
Fig. 4 is an exploded oblique view of the flavor inhaler.
Fig. 5 is an oblique view of a chamber.
Fig. 6 is a cross-sectional view of the chamber as viewed in the direction of the arrows 6-6 shown in fig. 5.
Fig. 7A is a cross-sectional view of the chamber as viewed in the direction of the arrows 7A-7A shown in Fig. 6.
Fig. 7B is a cross-sectional view of the chamber as viewed in the direction of the arrows 7B-7B shown in Fig. 6.
Fig. 8 is a cross-sectional view, as viewed in the direction of the arrows 7B-7B, of a state in which the flavor generating article has been disposed in a desired position within the chamber 50.
Fig. 9 is an exploded oblique view of a flavor generating article.
Fig. 10 is a schematic cross-sectional side view of the flavor generating article.
Fig. 11 is an exploded oblique view of a flavor generating article according to another embodiment.
Fig. 12 is an oblique view showing a flavor generating assembly.
Fig. 13 is an exploded oblique view of a battery.

### DESCRIPTION OF EMBODIMENTS

Embodiments of the present invention will be described below with reference to the drawings. In the drawings described below, identical or corresponding components are assigned the same reference symbols and duplicate descriptions will not be given. Dimensions of parts in the drawings below are altered, as appropriate, for ease of understanding.

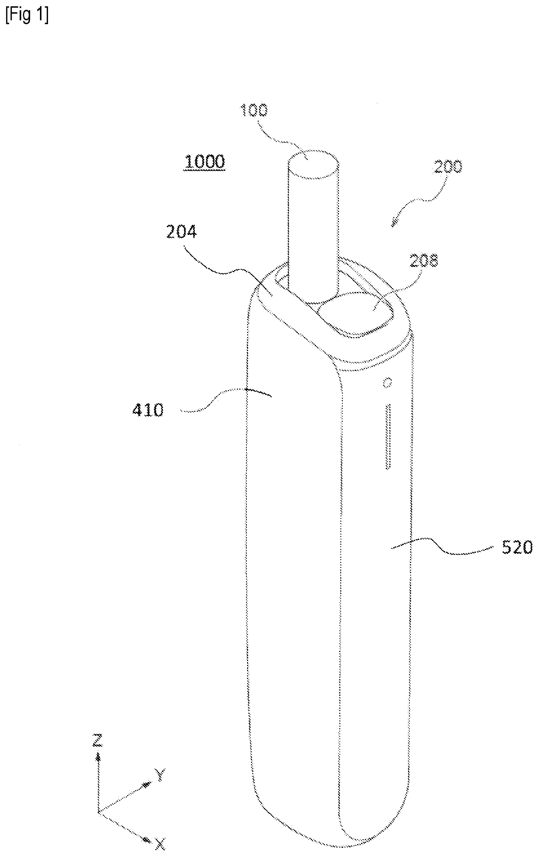

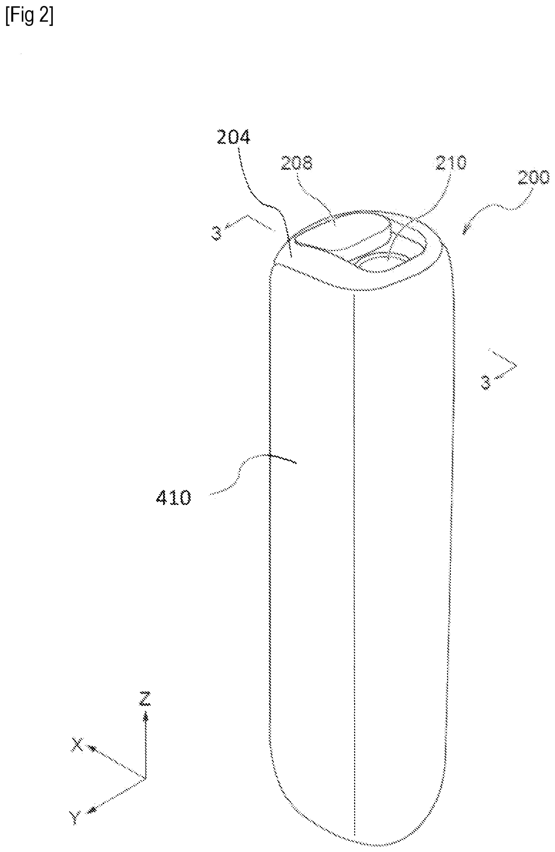

Fig. 1 is an oblique view showing a flavor generating system 1000 according to an embodiment of the present invention. Fig. 2 is an oblique view showing a flavor inhaler 200 according to an embodiment of the present invention. The flavor generating system 1000 is constructed by applying a flavor generating article 100 to a flavor inhaler 200 including a heating portion 40, discussed hereinafter. The flavor generating article 100 is at least partially accommodated in the flavor inhaler 200 via an insertion opening 210.

An X-Y-Z orthogonal coordinate system may be applied to the drawings described in the present specification for convenience of description. In this coordinate system, the Z-axis is oriented vertically upward, the X-Y plane is arranged cutting across the flavor inhaler 200 in a horizontal direction, and the Y-axis is arranged extending from a side face to a rear face of the flavor inhaler 200. The Z-axis direction may also refer to a direction of insertion of the flavor generating article 100 which is accommodated in a chamber 50 to be described later. Furthermore, the X-axis direction may also refer to a device longitudinal direction in a plane orthogonal to the insertion direction of the flavor generating article 100. The Y-axis direction may also refer to a device short-side direction in a plane orthogonal to the insertion direction of the flavor generating article 100.

The flavor inhaler 200 is configured to generate an aerosol containing a flavor by, for example, heating a stick-type flavor generating article 100 including a flavor source containing an aerosol source. As an example, the flavor generating article 100 comprises, on a tip end side in the Z-axis negative direction, a smokable material that contains a flavor source such as tobacco, and an aerosol source, and also comprises a filter in another part. Examples of aerosol sources that may be cited include glycerol, propylene glycol, triacetin, 1,3-butanediol, and mixtures thereof. The flavor generating article 100 is configured to be heated by means of a heat-not-burn flavor inhaler 200 to generate a flavor. The flavor inhaler 200 is preferably of a heat-not-burn tobacco type.

It should be noted that, in the embodiments, the flavor generating article 100 is described as being stick-shaped, but the flavor generating article used in the flavor inhaler 200 is not limited to that shape. For example, the flavor generating article may also be configured to contain a cartridge accommodating a liquid aerosol source. Furthermore, this cartridge may include a heater.

As shown in fig. 1 and fig. 2, the flavor inhaler 200 comprises an upper member 204, an outer case 410, an outer panel 520 and a lid 208. The movable lid 208 is disposed in the upper member 204. The lid 208 is preferably a sliding cover. The outer case defines a portion of an outer face of the flavor inhaler 200 and is sized to fits in a user's hand. When the user is using the flavor inhaler 200, the user can inhale the aerosol while holding the flavor inhaler 200 in their hand.

The outer case 410 is preferably formed from a metal such as aluminum, magnesium or titanium, or an alloy containing aluminum, magnesium or titanium, etc., from the viewpoint of efficiently dissipating heat from the heating portion 40 to the outside. However, the outer case 410 is not limited to the above materials and may also be made of a resin, for example, and it is possible to select any suitable material, such as, in particular, polycarbonate (PC), ABS (acrylonitrile-butadiene-styrene) resin, PEEK (polyether ether ketone), or a polymer alloy containing multiple types of polymers.

The upper member 204 includes the insertion opening 210 for accepting the flavor generating article 100, and the lid 208 is slidably attached to the upper member 204 so as to close the insertion opening 210. Specifically, the lid 208 is configured to be capable of moving along an outer face of the upper member 204 between a closed position for closing the insertion opening 210 of the upper member 204, and an open position (the position shown in fig. 1 and fig. 2) for opening the insertion opening 210. For example, the user can manually operate the lid 208 to move the lid 208 between the closed position and the open position. By this means, the lid 208 can permit or restrict access of the flavor generating article 100 to the inside of the flavor inhaler 200.

The upper member 204 preferably comprises at least one of a metal and a resin such as PC. The metal contained in the upper member 204 can be aluminum, magnesium or titanium, or an alloy comprising aluminum, magnesium or titanium, etc. However, the upper member 204 is not limited to the above materials, and it is possible to select any suitable material, such as ABS resin, PEEK, or a polymer alloy containing multiple types of polymers. From the viewpoint of achieving a uniform aesthetic appearance, it is preferable that the material of the upper member 204 is the same as the material of the outer case 410. Conversely, from the viewpoint of making the insertion opening 210 stand out, it is preferable that the material of the upper member 204 is different from the material of the outer case 410.

In the flavor generating system 1000, air drawn in by the user is introduced from the insertion opening 210 into the flavor inhaler 200, flows through the chamber 50 in the Z-axis negative direction, and is supplied to an upstream-side end face of the flavor generating article 100. That is to say, the flavor generating system 1000 shown in fig. 1 has what is known as a counterflow-type air flow path. It should be noted that the air flow path is not limited to a counterflow-type, and may equally be what is known as a bottom-flow-type air flow path, in which air is supplied into the chamber 50 from a vent port formed in a bottom portion of the chamber 50, and is supplied to the upstream-side end face of the flavor generating article 100.

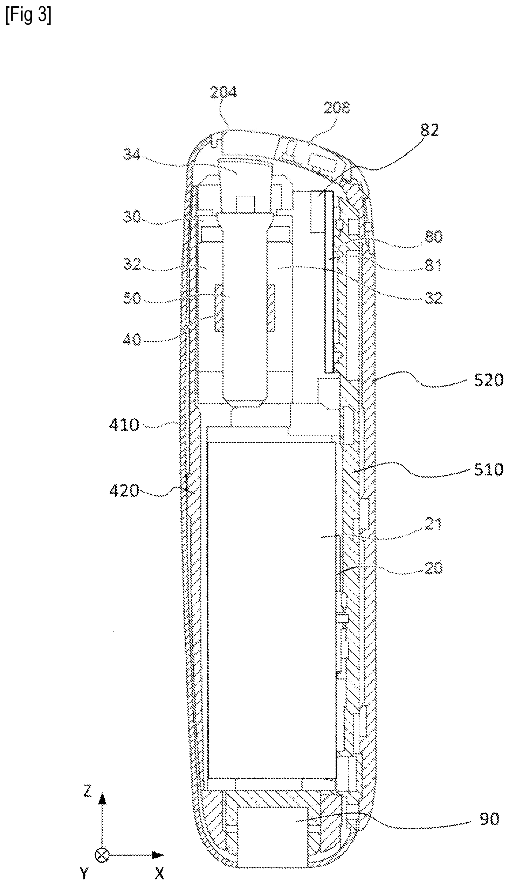

The internal structure of the flavor inhaler 200 according to an embodiment of the present invention will be described next. Fig. 3 is a cross-sectional view showing the flavor inhaler 200 as viewed in the direction of the arrows 3-3 shown in fig. 2. As shown in fig. 3, a power source portion 20, an atomizing portion 30, and a control portion 80 are provided in an internal space of flavor inhaler 200. An inner case 420 and inner panel 510 will be described later.

The control unit 80 includes a circuit board 81. The circuit board 81 may include a microprocessor, etc., for example, and may control the supply of power from the power source portion 20 to the atomizing portion 30. This enables the control portion 81 to control heating of the flavor generating article 100 by the atomizing portion 30 (heating portion 40). In addition, the control portion 80 includes a communication element 82 such as a Bluetooth (registered trademark) interface. The control portion 80 can communicate with an external device via the communication element 82.

The power source portion 20 comprises a battery 21 which is electrically connected to the circuit board 81 of the control portion 80. The battery 21 is a rechargeable battery such as a lithium ion secondary battery or a non-rechargeable battery, for example. The battery 21 is electrically connected to the atomizing portion 30 via the circuit board 81. This allows the battery 21 to supply power to the atomizing portion 30 to heat the flavor generating article 100 appropriately.

The atomizing portion 30 comprises: the chamber 50, which extends in the longitudinal direction of the flavor generating article 100; the heating portion 40, which surrounds part of the chamber 50; a heat insulating portion 32; and a substantially cylindrical insertion guide member 34. The chamber 50 has a tubular shape for accommodating the flavor generating article 100. It should be noted that the chamber 50 may also have what is known as an elliptical shape having a major diameter and a minor diameter in a cross section perpendicular to the longitudinal direction of the flavor inhaler 200. The chamber 50 is preferably formed from a material that is heat resistant and has a low coefficient of thermal expansion, and may, for example, be formed from a metal such as stainless steel, a resin such as PEEK, glass, or ceramic.

The heating portion 40 is configured to heat the flavor generating article 100. Specifically, the heating portion 40 is configured to contact an outer circumferential face of the chamber 50 to heat the flavor generating article 100 accommodated in the chamber 50. The heating portion 40 may be a heat generating body that generates heat by means of electric power from the power source portion 20, which is to say that the temperature thereof rises. The heating portion 40 may be a sheet-like heater such as a film heater. The heating portion 40 may be provided so as to contact the outer circumferential face of the chamber 50, or may be provided on an inner face of the chamber 50. Here, the length of the heating portion 40 in the longitudinal direction is 10 mm, for example. The heater constituting the heating portion 40 may comprise a heating wire. The heater is disposed outside the chamber 50, which functions as an accommodating portion for accommodating the flavor generating article, and is configured to heat the flavor generating article 100 accommodated in the chamber 50 from outside the flavor generating article 100. The flavor inhaler 200 is thus preferably an external heating type flavor inhaler. It should be noted that the heating portion 40 is an induction coil disposed in the flavor inhaler 200, and may be configured to inductively heat a susceptor disposed in the flavor generating article 100. Alternatively, the heating portion 40 may be a microwave radiation source disposed in the flavor inhaler 200, and may be configured to heat a microwave absorber such as water or glycerin contained in the flavor generating article 100 by means of microwaves. Also, the flavor inhaler 200 may be of an internal heating type, in which case the heating portion 40 may be a pin-type or blade-type heater.

The heat insulating portion 32 is disposed surrounding the chamber 50 and the heating portion 40 and suppresses dissipation of heat to the outside of the chamber 50. The heat insulating portion 32 may be an aerogel, for example. A heat diffusing member such as a graphite sheet may be disposed between the heat insulating portion 32 and the chamber 50. The graphite sheet is preferably formed of a material which has high diffusivity in the planar direction of the sheet and low diffusivity in the thickness direction. The heat diffusing member may be disposed between the heat insulating portion 32 and the heating portion 40, such as a film heater, or may be disposed between the heating portion 40, such as a film heater, and the chamber 50. The insertion guide member 34 is formed from a resin material such as PEEK, PC or ABS, for example, and is provided between the lid 208, in the closed position, and the chamber 50. The insertion guide member 34 communicates with the outside of the flavor inhaler 200 when the lid 208 is in the open position, guiding insertion of the flavor generating article 100 into the chamber 50 when the flavor generating article 100 is inserted into the insertion guide member 34.

The flavor inhaler 200 may further include a terminal 90. The terminal 90 may be an interface for connecting the flavor inhaler 200 to an external power source, for example. If the battery 21 is a rechargeable battery, connecting an external power source to the terminal 90 allows a current to flow from the external power source to the battery 21, thereby charging the battery 21. Furthermore, data relating to the operation of the flavor inhaler 200 may also be sent to an external device by connecting a data transmission cable to the terminal 90.

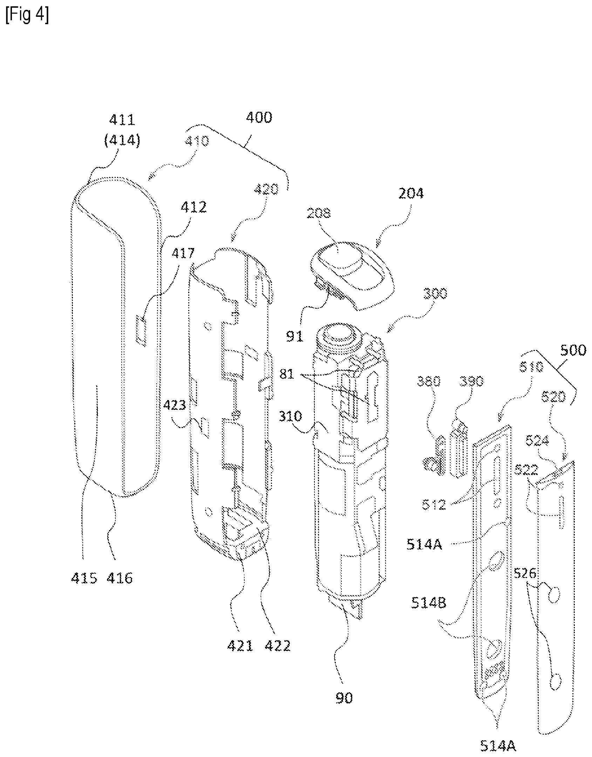

Fig. 4 is an exploded oblique view of the flavor inhaler 200. The flavor inhaler 200 has a flavor generating assembly 300, a case portion 400 and a panel portion 500. The case portion 400 comprises an outer case 410 and an inner case 420. The panel portion 500 comprises the inner panel 510, and the outer panel 520. It should be noted that the inner case 420 may be configured as part of the flavor generating assembly 300. In the illustrated example, the case portion 400 comprises two cases, the outer case 410 and the inner case 420, but the number of cases of the case portion 400 is not particularly limited and may be one or three or more. Also, in the illustrated example, the panel portion 500 comprises two panels, but the number of panels of the panel portion 500 is not particularly limited, and may be one or three or more.

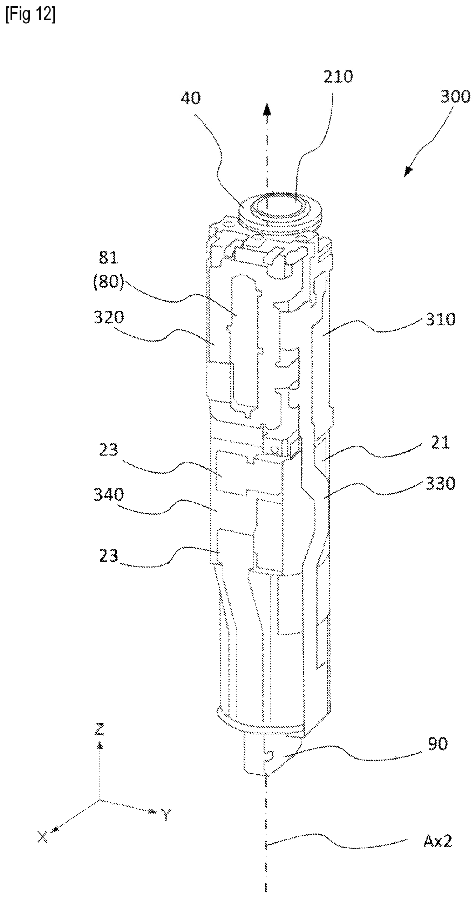

The flavor generating assembly 300 is an assembly that includes the heating portion 40 (fig. 3) and the control portion 80. Preferably, the flavor generating assembly 300 additionally includes the chamber 50 or the power source portion 20. The flavor generating assembly 300 has a chassis 310. In the flavor generating assembly 300, the power source portion 20, the atomizing portion 30, the circuit board 81 and a flexible printed circuit board (FPC, fig. 12), etc., are arranged on the chassis 310, which serves as a supporting body or a base. The flavor generating assembly 300 is configured such that each part is stably supported while ensuring electrical connection between the parts. The flavor generating assembly 300 is preferably stick-shaped in order to facilitate insertion thereof into the case portion 400.

The outer case 410 extends in its longitudinal direction and has a first end 414, a second end 416 on the opposite side to the first end 414 in the longitudinal direction, and a side face 415 extending from the first end 414 side to the second end 416 side. A first opening portion 411 is formed in the end face at the first end 414, and a second opening portion 412 is formed in the side face 415. The first opening portion 411 and the second opening portion 412 are connected to form one opening. The outer case 410 accommodates the inner case 420 and the flavor generating assembly 300.

The inner case 420 is a case arranged inside the outer case 410 and accommodates the flavor generating assembly 300. The inner case 420 is arranged to facilitate insertion of the flavor generating assembly 300 and to more stably support the flavor generating assembly 300. As shown in fig. 4, the inner case 420 has a bottom member 421. The bottom member 421 has an upper face 422 supporting the flavor generating assembly 300 and is configured such that the terminal 90 passes therethrough. The upper face 422 preferably extends substantially horizontally. The second end 416 of the outer case 410 is curved from the perspective of aesthetics or ease of holding, but the presence of the bottom member 421 allows the flavor generating assembly 300 to be more stably supported.

The material of the inner case 420 is not particularly limited, and may contain, for example, a resin material such as PC, PEEK, or ABS, or a metal. The metal contained in the inner case 420 may be aluminum, magnesium or titanium, or an alloy including aluminum, magnesium or titanium, etc. It should be noted that the flavor inhaler 200 does not need to include the inner case 420, and the outer case 410 may be a single case that accommodates the flavor generating assembly 300.

The flavor generating assembly 300 is accommodated in the outer case 400 in such a way that the circuit board 81 is disposed on the second opening portion 412 side. The circuit board 81 preferably defines a portion of the face of the flavor generating assembly 300 on the second opening portion 412 side. This inhibits situations in which the circuit board 81 or elements in the vicinity of the circuit board 81 come into contact with and damage the case portion 400 or the like when the flavor generating assembly 300 is inserted into the case portion 400. Also, even if the communication element 82 (fig. 3) is disposed close to the circuit board 81, the flavor inhaler 200 can be made compact since communication is unlikely to be obstructed by the case portion 400 or the like. Furthermore, the circuit board 81 can be accessed after the flavor generating assembly 300 has been inserted into the outer case 400. For example, the circuit board 81 can be attached to or detached from the flavor generating assembly 300 accommodated in the outer case 400, and elements can be added to or removed from the circuit board 81 by soldering or the like.

In the flavor generating assembly 300, the atomizing portion 30 including the heating portion 40 is preferably disposed on the opposite side of the circuit board 81 to the second opening portion 412 side. The heating portion 40 is preferably disposed on the opposite side to the second opening portion 412 side with respect to a central axis Ax2 (fig. 12) extending in the longitudinal direction of the flavor generating assembly 300. This allows heat to be dissipated efficiently from the heating portion 40 via the case portion 400. It is more preferable that the outer case 410 and/or the inner case 420 contains a metal such as aluminum, magnesium, or titanium, or an alloy containing aluminum, magnesium, or titanium, etc., since this promotes heat dissipation.

The upper member 204 is disposed on the first opening portion 411 side of the flavor generating assembly 300. Preferably, the lid 208 disposed in the upper member 204 is capable of moving between a position corresponding to the insertion opening 210 through which the flavor generating article 100 is inserted and a position corresponding to the circuit board 81, in coordinates on a plane perpendicular to the longitudinal direction. If a magnet that moves integrally with the lid 208 is disposed on the lid 208, a mechanism for detecting the position of the lid 208 can be compactly configured by disposing a magnetic sensor on the circuit board 81.

The panel portion 500 is configured to cover the second opening portion 412. The inner panel 530A is a panel that corresponds to the shape of the second opening portion 412 and that extends in the longitudinal direction of the outer case 410 so as to cover the second opening portion 412. The inner panel 510 is disposed inward of the outer panel 520. The outer panel 520 is configured to cover at least a portion of the inner panel 510. The outer panel 520 is preferably removably attached to the inner panel 510 or the like. In the illustrated example, the outer panel 520 is attracted to the inner panel 510 by means of magnetic force, as discussed hereinbelow. In addition, the outer panel 520 has a protrusion 524 which is inserted into a recessed portion, not shown, of the upper member 204 to more stably hold the outer panel 520 and facilitate attachment of the outer panel 520.

The inner panel 510 and the outer panel 520 may be formed from resin or metal, for example. Each of the inner panel 510 and the outer panel 520 may be formed partly from resin and partly from metal. The resin contained in the inner panel 510 or the outer panel 520 is, for example, PC, ABS resin, PEEK or a polymer alloy. The metal contained in the inner panel 510 or the outer panel 520 may be aluminum, magnesium or titanium, an alloy containing aluminum, magnesium or titanium, or stainless steel, for example.

The upper member 204 has first connecting portions 91 for connecting to the outer case 410, the inner case 420, the flavor generating assembly 300, or at least one panel of the panel portion 500. The first connecting portions 91 may have an engagement portion, such as a claw portion, and engage with other members, may have a fastening portion such as a screw hole and connect with other members by fastening, may have a fitting portion such as a protruding portion or a recessed portion and connect with other members by fitting, or may have an adhesive applied face and connect with other members by adhesion. Alternatively, the first connecting portions 91 may have a magnetic member or a magnet and be attracted to another member by means of a magnetic force. In fig. 4, the first connecting portions 91 are claw portions and are configured to engage with the outer case 410 or the inner case 420. The first connecting portions 91 make it possible to assemble the flavor inhaler 200 more reliably and easily.

At least one panel included in the panel portion 500 may have second connecting portions 514, 526. The inner panel 510 has second connecting portions 514 for connecting to the upper member 204, the outer case 410, the inner case 420, the flavor generating assembly 300, or the outer panel 520, which is another of the at least one panels. The second connecting portions 514 may have an engagement portion, such as a claw portion, and engage with other members, may have a fastening portion such as a hole through which a screw passes and connect with other members by fastening, may have a fitting portion such as a protruding portion or a recessed portion and connect with other members by fitting, or may have an adhesive applied face and connect with other members by adhesion. Alternatively, the second connecting portions 514 may have a magnetic member or a magnet and be attracted to another member by means of a magnetic force. In fig. 4, the second connecting portions 514A are holes through which screws pass, and the inner panel 510 is configured to be fastened to the flavor generating assembly 300 using screws. Furthermore, the second connecting portions 514B are magnetic members that are configured to be attracted to the second connecting portions 526, which are magnets on the outer panel 520. The second connecting portions 514 make it possible to assemble the flavor inhaler 200 more reliably and easily.

The outer panel 520 includes the second connecting portions 526 for removable connection to the upper member 204, the outer case 410, the inner case 420, the flavor generating assembly 300, or the inner panel 510, which is another of the at least one panels. The second connecting portions 526 may have an engagement portion, such as a claw portion, and engage with other members, may have a fastening portion such as a hole through which a screw passes and connect with other members by fastening, may have a fitting portion such as a protruding portion or a recessed portion and connect with other members by fitting, or may have an adhesive applied face and connect with other members by adhesion. Alternatively, the second connecting portions 526 may have a magnetic member or a magnet and be attracted to another member by means of a magnetic force. In fig. 4, the second connecting portions 526 are magnets, and are configured to be attracted to the magnetic members 514B of the inner panel 510. In fig. 4, the second connecting portions 526 provided on the face of the outer panel 520 on the inner panel 510 side are shown schematically by dashed lines. The magnets may be disposed on the inner panel 510, but are preferably disposed on the outer panel 520 to reduce the risk of adversely affecting elements in the vicinity of the circuit board 81. The second connecting portions 526 make it possible to assemble the flavor inhaler 200 more reliably and easily.

The outer case 410 has third connecting portions 417 for connecting to the upper member 204, the inner case 420, the flavor generating assembly 300, or at least one panel of the panel portion 500. The third connecting portions 417 may have an engagement portion, such as a claw portion, and engage with other members, may have a fastening portion such as a hole through which a screw passes and connect with other members by fastening, may have a fitting portion such as a protruding portion or a recessed portion and connect with other members by fitting, or may have an adhesive applied face and connect with other members by adhesion. Alternatively, the third connecting portions 417 may have a magnetic member or a magnet and be attracted to another member by means of a magnetic force. In fig. 4, the third connecting portions 417 are recessed portions and are configured to connect by fitting to projecting portions of the inner case 420. The third connecting portions 417 make it possible to assemble the flavor inhaler 200 more reliably and easily.

The inner case 420 has fourth connecting portions 423 for connecting to the upper member 204, the outer case 410, the flavor generating assembly 300, or at least one panel of the panel portion 500. The fourth connecting portions 423 may have an engagement portion, such as a claw portion, and engage with other members, may have a fastening portion such as a hole through which a screw passes and connect with other members by fastening, may have a fitting portion such as a protruding portion or a recessed portion and connect with other members by fitting, or may have an adhesive applied face and connect with other members by adhesion. Alternatively, the fourth connecting portions 423 may have a magnetic member or a magnet and be attracted to another member by means of a magnetic force. In fig. 4, the fourth connecting portions 423 are protruding portions and are configured to connect by fitting to recessed portions of the outer case 420. The fourth connecting portions 423 make it possible to assemble the flavor inhaler 200 more reliably and easily.

As discussed hereinabove, the flavor inhaler 200 may include at least one panel of the panel portion 500 which is disposed on the second opening portion 412 side of the flavor inhaler 200, and/or the upper member 204 which is located on the first end 414 side and in which the movable lid 208 is disposed. As a result, the first opening portion 411 or the second opening portion 412 can be covered, and the parts of the flavor generating assembly 300 that are exposed in the first opening portion 411 or the second opening portion 412 can be protected.

As shown in fig. 4, the flavor inhaler 200 may have a tactile switch 380 and a display portion 390. The tactile switch 380 has an ON state when pressed and an OFF state when not pressed, and is configured to generate different electrical signals in a circuit on the circuit board 81 in the ON state and the OFF state. For example, the tactile switch 380 is configured to energize the circuit in the ON state and not energize the circuit in the OFF state. The tactile switch 380 functions as an input portion for accepting input from the user.

The display portion 390 has at least one of a light source, such as a light emitting diode, and a screen consisting of a plurality of pixels. In the illustrated example, the inner panel 510 has through-holes 512 that penetrate through in the thickness direction, and the outer panel 520 has window portions 522 in positions facing the through-holes 512 in the thickness direction. The display portion 390 is configured such that translucent display window portions forming optical paths are inserted into the through-holes 512, and is configured to emit light to the outside of the flavor inhaler 200 through the translucent window portions 522 of the outer panel 520.

Also, in the present embodiment, at least the part of the inner panel 510 in the vicinity of the through-holes 512 and at least the part of the outer panel 520 in the vicinity of the window portions 522 are configured to be elastically deformable under a pressing force from the user. Furthermore, the tactile switch 380 is disposed facing the display portion 390 in the thickness direction of the inner panel 510, and is configured such the tactile switch 380 switches between an ON state and an OFF state under a pressing force from the user.

It should be noted that, instead of or in addition to the tactile switch 380, the flavor inhaler 200 may include any interface, such as a button or a touch panel, that accepts input from the user. Also, the form of the display portion 390 and the optical path are not particularly limited to the above example, provided that the user is able to acquire information via the display portion 390.

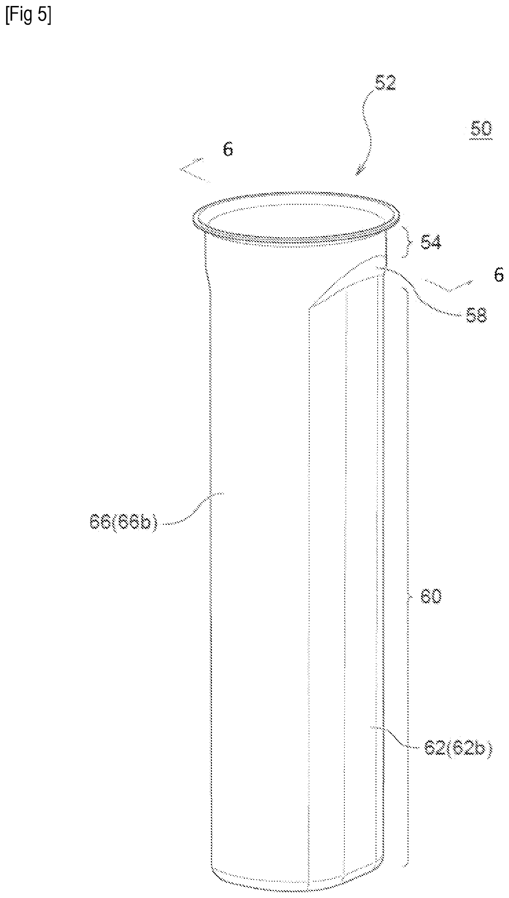

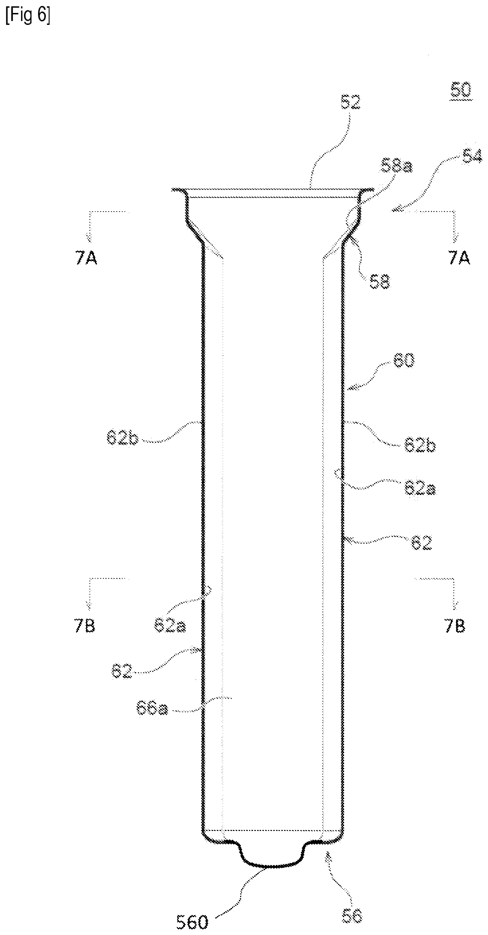

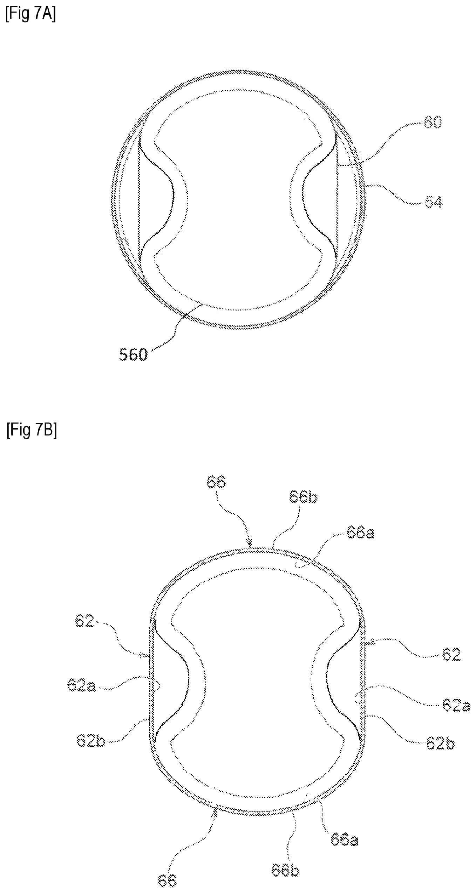

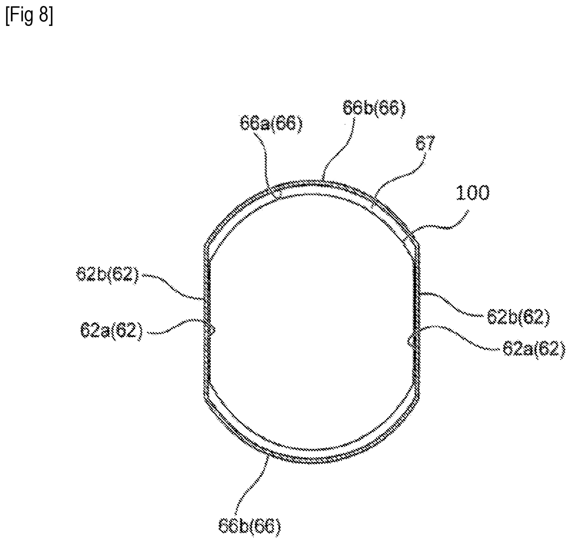

Fig. 5 is an oblique view of the chamber 50. Fig. 6 is a cross-sectional view of the chamber 50 as viewed in the direction of the arrows 6-6 shown in fig. 5. Fig. 7A is a cross-sectional view of the chamber 50 as viewed in the direction of the arrows 7A-7A shown in fig. 6. Fig. 7B is a cross-sectional view of the chamber 50 as viewed in the direction of the arrows 7B-7B shown in fig. 6. Fig. 8 is a cross-sectional view, as viewed in the direction of the arrows 7B-7B, of a state in which the flavor generating article 100 has been disposed in a desired position within the chamber 50.

As shown in fig. 5 and fig. 6, the chamber 50 may be a tubular member including a chamber opening 52 into which the flavor generating article 100 is inserted, and a tubular side wall portion 60 that accommodates the flavor generating article 100.

As shown in fig. 6 and fig. 7, the side wall portion 60 includes contacting portions 62 and spaced-apart portions 66. When the flavor generating article 100 is disposed in a desired position within the chamber 50, the contacting portions 62 contact or press a portion of the flavor generating article 100, and the spaced-apart portions 66 are spaced apart from the flavor generating article 100. It should be noted that, in the present disclosure, "a desired position within the chamber 50" refers to a position in which the flavor generating article 100 is heated appropriately, or the position of the flavor generating article 100 when the user inhales flavor. The contacting portions 62 each have an inner surface 62a and an outer surface 62b. The spaced-apart portions 66 each have an inner surface 66a and an outer surface 66b. The heating portion 40 is disposed on the outer surfaces 62b of the contacting portions 62. The heating portion 40 is preferably disposed on the outer surfaces 62b of the contacting portions 62 without a gap. It should be noted that the heating portion 40 may contain an adhesive layer. In this case, the heating portion 40 containing the adhesive layer is preferably disposed on the outer surfaces 62b of the contacting portions 62 without a gap.

As shown in fig. 5 and 6, the outer surfaces 62b of the contacting portions 62 are planar. Since the outer surfaces 62b of the contacting portions 62 are planar, if strip-shaped electrodes connected to the heating portion 40 are disposed on the outer surfaces 62b of the contacting portions 62, flexing of the electrodes can be suppressed. As shown in fig. 6 and fig. 7, the inner surfaces 62a of the contacting portions 62 are planar. Furthermore, as shown in fig. 6 and fig. 7, the contacting portions 62 have a uniform thickness.

As shown in fig. 5 and fig. 6, the chamber 50 preferably has a cylindrical non-holding portion 54 between the chamber opening 52 and the side wall portion 60. In a state in which the flavor generating article 100 is positioned in a desired position in the chamber 50, gaps may be formed between the non-holding portion 54 and the flavor generating article 100. Furthermore, as shown in fig. 5 and fig. 6, the chamber 50 preferably has chamber guide portions 58 having tapered surfaces 58a that connect the inner surface of the non-holding portion 54 and the inner surfaces 62a of the contacting portions 62.

As shown in fig. 5, fig. 6 and fig. 7B, the chamber 50 has two contacting portions 62 in the circumferential direction of the chamber 50, and the two contacting portions 62 face each other and are substantially parallel to each other. The distance between the inner surfaces 62a of the two contacting portions 62 is, at least partially, preferably less than the width of the part of the flavor generating article 100 that is disposed between the contacting portions 62 when inserted into the chamber 50.

As shown in Fig. 7B, the inner surfaces 66a of the spaced-apart portions 66 may have an overall arc-shaped cross-section in a plane orthogonal to the longitudinal direction (Z-axis direction) of the chamber 50. Furthermore, the spaced-apart portions 66 are arranged so as to be adjacent to the contacting portions 62 in the circumferential direction.

As shown in fig. 6 and 7A, a step 560 is formed in the bottom portion 56 of the chamber 50. The step 560 is configured to expose at least a portion of the end face of the flavor generating article 100. Furthermore, the bottom portion 56 may support a portion of the flavor generating article 100 such that the exposed end face of the flavor generating article 100 communicates with voids 67 (see fig. 8) discussed hereinafter. The step 560 is not limited to the illustrated shape provided that air can be introduced into the flavor generating article 100.

Fig. 8 is a cross-sectional view at the same position as in fig. 7B, in a state in which the flavor generating article 100 is disposed in the desired position within the chamber 50. As shown in fig. 8, when the flavor generating article 100 is disposed in the desired position within the chamber 50, the flavor generating article 100 may come into contact with and be pressed by the contacting portions 62 of the chamber 50. Meanwhile, voids 67 are formed between the flavor generating article 100 and the spaced-apart portions 66. The voids 67 may provide communication between the chamber opening 52 and the end face of the flavor generating article 100 positioned within the chamber 50. This allows air that has flowed in from the chamber opening 52 to pass through the voids 67 and flow into the inside of the flavor generating article 100. In other words, air flow paths (the voids 67) are formed between the flavor generating article 100 and the spaced-apart portions 66.

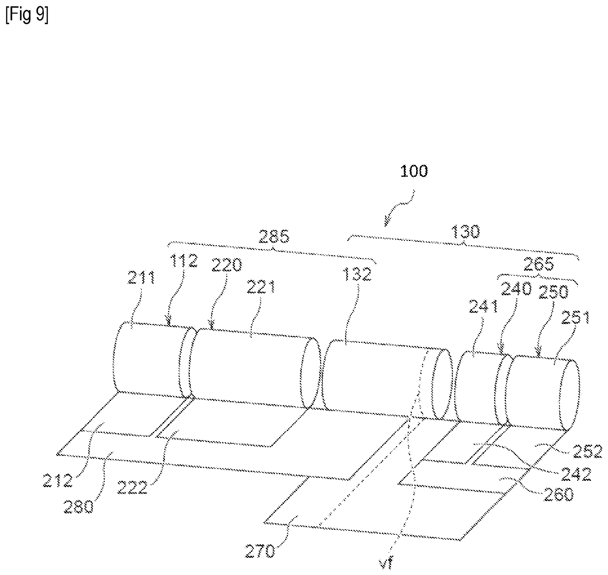

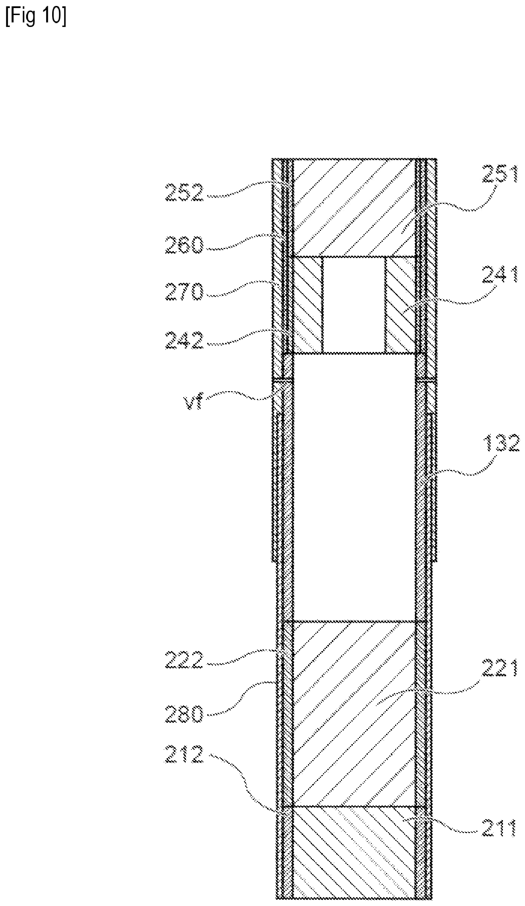

Fig. 9 is an exploded oblique view of the flavor generating article 100. Furthermore, fig. 10 is a schematic cross-sectional side view of the flavor generating article 100. As shown in fig. 9 and fig. 10, the flavor generating article 100 comprises: a flavor source 221 for generating a flavor; and a tip-end plug 112 disposed on the upstream side of the flavor source 221. More specifically, in the illustrated example, the flavor generating article 100 comprises, in order from the tip-end side (i.e., the opposite side to a mouthpiece): the tip-end plug 112; a flavor-generating portion 220; a hollow tube portion 132; a hollow filter 240; and a filter plug 250. These five components are joined by using an outer plug wrap 280, an outer plug wrap 260, and a tipping paper 270.

The flavor-generating portion 220 is disposed adjacently downstream of the tip-end plug 112. The flavor-generating portion 220 comprises: the flavor source 221, and a wrapping paper 222 wrapped around the flavor source 221. There is no particular restriction on the form of the flavor-generating portion 220 provided that it has a well-known form, and it is normally in a form in which the flavor source 221 is wrapped with the wrapping paper 222. The flavor-generating portion 220 is formed by wrapping the flavor source 221 with the wrapping paper 222 so that the flavor source 221 is on the inside.

The flavor source 221 may include at least one of a flavoring such as menthol and a natural material such as tobacco. The flavor source 221 may contain a tobacco filler. The tobacco filler is not particularly restricted, and may comprise at least one of tobacco shreds and tobacco sheets obtained by processing tobacco shreds into sheets. The flavor-generating portion 220 may contain an aerosol source. There is no particular limitation as to the type of aerosol source, and extracts from various types of natural products and/or components thereof may be selected depending on the purpose of use.

There is no particular restriction on the configuration of the wrapping paper 222 used in the flavor generating article 100, and it may take a general form. Specifically, the wrapping paper may comprise pulp as its main component, for example. Pulps which may be used include wood pulps such as softwood pulp and hardwood pulp, flax pulp, hemp pulp, sisal pulp, and esparto, etc., and it is possible to use a pulp which is generally used in a wrapping paper for a tobacco product, and the wrapping paper may be obtained by a papermaking process employing one or more of these pulps. These pulps may be used alone, or several types of pulps may be combined in any proportions for use. Forms of pulp which may be used include chemical pulp, ground pulp, chemiground pulp, and thermomechanical pulp, etc. which are obtained by means of kraft digestion, acid/neutral/alkaline sulfite digestion, and soda digestion, etc.

As shown in fig. 9 and 10, the tip-end plug 112 is positioned at the tip end of the flavor generating article 100 and is configured to cover the end portion of the flavor source 221. This makes it possible to prevent the flavor source 221 from falling out from the flavor generating article 100. Specifically, the tip-end plug 112 comprises a first filler material 211, and a first inner plug wrap 212 wrapped around the first filler material 211. The tip-end plug 112 may further include an aerosol source carried by the first filler material 211.

There is no particular restriction on the material of the first inner plug wrap 212 and a well-known material may be used. The first inner plug wrap 212 may contain a filler such as calcium carbonate, or the like. There is no particular restriction on the thickness of the first inner plug wrap 212, and it is normally 20 µm-140 µm, preferably 30 µm-130 µm, and more preferably 30 µm-120 µm. There is no particular restriction on the basis weight of the first inner plug wrap 212, but it is normally 20 gsm-100 gsm, preferably 22 gsm-95 gsm, and more preferably 23 gsm-90 gsm. Furthermore, the first inner plug wrap 212 may be coated or uncoated, but is preferably coated with a desired material from the viewpoint of allowing functions other than strength and structural rigidity to be imparted.

As shown in fig. 9, the flavor generating article 100 preferably has a downstream portion 130 disposed on the downstream side of the flavor source 221. In this case, the vapor or aerosol generated by the flavor source 221 can be cooled and filtered in the downstream portion 130. Specifically, the downstream portion 130 preferably includes the filter plug 250. This enables the vapor or aerosol generated by the flavor source to be cooled and filtered in the filter plug 250.

The filter plug 250 is positioned in the end portion, on the mouthpiece side, of the flavor generating article 100. The filter plug 250 comprises a second filler material 251, and a second inner plug wrap 252 wrapped around the second filler material 251. There is no particular restriction as to the filter material used in the second filler material 251, provided that it has the general functions of a filter. Examples of general functions of the filter which may be cited include adjusting the amount of air which is mixed when the aerosol, etc. is drawn in, lightening the flavor, and lightening nicotine and tar, etc., but the filter material used in the second filler material 251 need not have all of these functions. Furthermore, in an electrically heated tobacco product, which generates fewer components and tends to have a lower filling ratio of tobacco filler than a cigarette product, an important function of the filter also lies in preventing the tobacco filler from falling out, while controlling a filtration function.

A material produced by means of a production method, discussed hereinafter, for example, may be used for the filter material constituting the second filler material 251 of the filter plug 250, and it is also possible to use a commercially available product. Furthermore, there is no particular restriction on the form of the filter plug 250, and it is possible to form a plain filter comprising a single filter segment, or a multi-segment filter comprising multiple filter segments, such as a dual filter or a triple filter, or the like.

There is no particular restriction on the form of the second filler material 251 constituting the filter plug 250, and a well-known form may be adopted. For example, a component obtained by processing cellulose acetate tow into a cylindrical shape may be used as the second filler material 251. In the case of a filter filled with cellulose acetate tow, triacetin may be added in an amount of 5 wt%-10 wt% with respect to the weight of the cellulose acetate tow, in order to improve filter hardness. Furthermore, a paper filter filled with sheet-like paper pulp may also be used instead of the acetate filter.

The filter plug 250 may include the second inner plug wrap 252 (wrapping paper) wrapped around the second filler material 251, discussed hereinafter, from the viewpoint of improving strength and structural rigidity. There is no particular restriction on the form of the second inner plug wrap 252, and it may include a seam comprising one or more lines of adhesive. There is no particular limitation as to the adhesive, but it may comprise a vinyl acetate-based adhesive or a hot-melt adhesive, and the hot-melt adhesive may comprise polyvinyl alcohol. Furthermore, if the filter segment comprises two or more segments, the second inner plug wrap 252 is preferably wrapped around both of these two or more segments.

There is no particular restriction on the material of the second inner plug wrap 252, and a well-known material may be used, and it may furthermore include a filler such as calcium carbonate, etc. There is no particular restriction on the thickness of the second inner plug wrap 252, and it is normally 20 µm-140 µm, preferably 30 µm-130 µm, and more preferably 30 µm-120 µm. There is no particular restriction on the basis weight of the second inner plug wrap 252, but it is normally 20 gsm-100 gsm, preferably 22 gsm-95 gsm, and more preferably 23 gsm-90 gsm. Furthermore, the second inner plug wrap 252 may be coated or uncoated, but is preferably coated with a desired material from the viewpoint of allowing functions other than strength and structural rigidity to be imparted.

As shown in fig. 9 and fig. 10, the hollow filter 240 and the filter plug 250 may be connected by the outer plug wrap 260 (outside wrap paper), for example. The outer plug wrap 260 may be a cylindrical paper, for example.

The downstream portion 130 may further comprise the hollow tube portion 132 and the hollow filter 240. The hollow filter 240 is disposed adjacently downstream of the hollow tube portion 132. The hollow filter 240 may comprise: a filtration material 241 having one or more hollow portions; and a third inner plug wrap 242 wrapped around the filtration material 241. There is no particular restriction on the third inner plug wrap 242, and the same plug wrap as used in cigarettes may, for example, be used. The third inner plug wrap 242 may be omitted. Furthermore, the hollow filter 240 may be omitted.

The hollow tube portion 132 is a rod-shaped member which is adjacently interposed between the flavor-generating portion 220 and the hollow filter 240 or the filter plug 250 (when there is no hollow filter 240), and is normally provided with a cavity which is cylindrical or the like, the circumferential cross section thereof forming a hollow (enclosed space). The length of the hollow tube portion 132 in the long axis direction may be appropriately varied according to the size of the product, but it is normally 15 mm or greater and preferably 20 mm or greater, and is normally 40 mm or less, preferably 35 mm or less, and more preferably 30 mm or less. By setting the length of the hollow tube portion 132 in the long axis direction at or above the abovementioned lower limit, it is possible to ensure a sufficient cooling effect and to obtain a pleasant flavor, and by setting the length at or below the abovementioned upper limit, it is possible to inhibit loss caused by adhesion of the generated vapor and aerosol to an inner wall of the hollow tube portion 132.

As shown in fig. 9 and 10, the hollow tube portion 132 may be provided with air flow holes vf (also referred to as a "ventilation filter" in this technical field) which are in the circumferential direction and concentric. The presence of the air flow holes vf allows air to flow into the hollow tube portion 132 from the outside during use, and enables a reduction in the temperature of air and components flowing in from the flavor-generating portion 220. The air flow holes vf may be provided in a region lying at least 4 mm in the direction of the hollow tube portion 132 side from a boundary between the hollow tube portion 132 and the hollow filter 240 or the filter plug 250 (when there is no hollow filter 240). In this case, the air flow holes vf can not only enhance the cooling capability of the hollow tube portion 132, but also can also suppress stagnation of components generated by means of heating inside the hollow tube portion 132, and increase the amount of delivery of those components. It should be noted that when an aerosol source is used in the flavor-generating portion 220, a vapor containing the aerosol source and the tobacco flavor component generated as a result of the flavor generating article 100 being heated is liquefied by a reduction in temperature caused by contact with external air, making it possible to promote aerosol generation.

There is no particular restriction on the configuration of the outer plug wrap 280, and it may take a general form. Specifically, the outer plug wrap 280 may comprise pulp as its main component, for example. Pulps which may be used include wood pulps such as softwood pulp and hardwood pulp, flax pulp, hemp pulp, sisal pulp, and esparto, etc., and it is possible to use a pulp which is generally used in a wrapping paper for a tobacco article, and the outer plug wrap 280 may be obtained by a papermaking process employing one or more of these pulps. These pulps may be used alone, or several types of pulps may be combined in any proportions for use. Forms of pulp which may be used include chemical pulp, ground pulp, chemiground pulp, and thermomechanical pulp, etc. which are obtained by means of kraft digestion, acid/neutral/alkaline sulfite digestion, and soda digestion, etc. It should be noted that a commercially available article may be used for the outer plug wrap 280. There is no particular restriction on the shape of the outer plug wrap 280, and it may have a square or rectangular shape, for example. The outer plug wrap 280 may include at least one of a filler, an auxiliary agent, and a coating agent.

There is no particular restriction on the configuration of the tipping paper 270, and it may take a general form. Specifically, the tipping paper 270 may comprise pulp as its main component, for example. Pulps which may be used include wood pulps such as softwood pulp and hardwood pulp, flax pulp, hemp pulp, sisal pulp, and esparto, etc., and it is possible to use a pulp which is generally used in a wrapping paper for a tobacco article, and the tipping paper 270 may be obtained by a papermaking process employing one or more of these pulps. These pulps may be used alone, or several types of pulps may be combined in any proportions for use. Forms of pulp which may be used include chemical pulp, ground pulp, chemiground pulp, and thermomechanical pulp, etc. which are obtained by means of kraft digestion, acid/neutral/alkaline sulfite digestion, and soda digestion, etc. It should be noted that a commercially available article may be used for the tipping paper 270. There is no particular restriction on the shape of the tipping paper 270, and it may have a square or rectangular shape, for example. Furthermore, the flavor generating article 100 may include one tipping paper 270, but it may equally include multiple tipping papers 270. The tipping paper 270 may include at least one of a filler, an auxiliary agent, a coating agent, and a lip-release material that assists in easy separation, substantially without adhesion, of the lips and the tipping paper 270 when the user holds the mouthpiece of the flavor generating article 100 in their mouth.

A mode of joining of the components constituting the flavor generating article 100 will be described next. In fig. 9, gaps are provided between the components to make it easier to see how the components are joined, but the components of the actual flavor generating article 100 are adjacent without gaps, as shown in fig. 10. In the flavor generating article 100 shown in fig. 9, the five components are joined by using the outer plug wrap 280, the outer plug wrap 260, and the tipping paper 270. Specifically, as shown in fig. 9, the outer plug wrap 280 joins the tip-end plug 112, the flavor-generating portion 220, and the hollow tube portion 132. Here, the outer plug wrap 280 is wound so as to cover the whole of the tip-end plug 112 and the flavor-generating portion 220, and part of the hollow tube portion 132. This joined body will be referred to as a first joined body 285. Furthermore, the outer plug wrap 260 is wound so as to join the hollow filter 240 and the filter plug 250 while also covering same in their entirety. This joined body will be referred to as a second joined body 265. The tipping paper 270 further joins the first joined body 285 and the second joined body 265. Here, the tipping paper 270 covers the whole of the second joined body 265 and part of the first joined body 285, while exposing the first joined body 285 at its upstream end. It should be noted that in the example shown in fig. 9, the outer plug wrap 280 exposes the hollow tube portion 132 at its downstream end, without covering the hollow tube portion 132 as far as its downstream end, but the hollow tube portion 132 may equally be covered as far as its downstream end. In this case, perforations are preferably provided in the outer plug wrap 280 and the tipping paper 270 at positions directly above the air flow holes vf provided in the hollow tube portion 132. As a result, the air flow holes vf are preferably provided so as to penetrate through the tipping paper 270, the outer plug wrap 280, and the hollow tube portion 132.

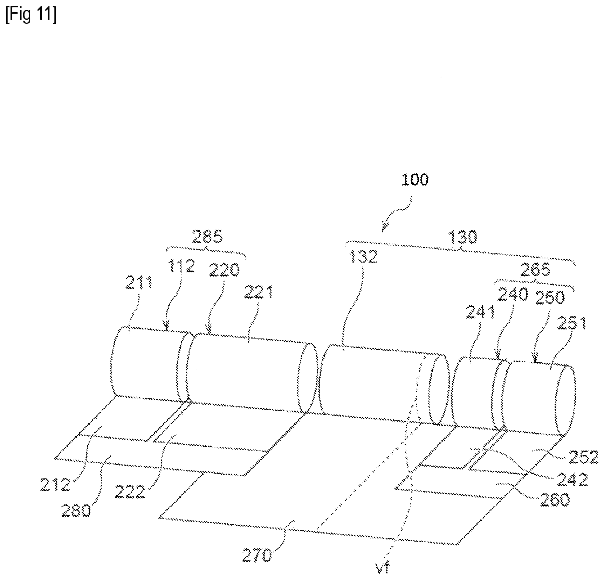

Fig. 11 is an exploded oblique view of a flavor generating article 100 according to another embodiment. The flavor generating article 100 shown in fig. 11 differs from the flavor generating article 100 shown in fig. 9 and 10 only in the mode of joining thereof. In the flavor generating article 100 shown in fig. 11, the five components are joined by using the outer plug wrap 280, the outer plug wrap 260, and the tipping paper 270. Specifically, as shown in fig. 11, the outer plug wrap 280 is wound so as to join the tip-end plug 112 and the flavor-generating portion 220 while also covering same in their entirety. This joined body will be referred to as a first joined body 285. Furthermore, in the example shown in fig. 11, the outer plug wrap 260 is wound so as to join the hollow filter 240 and the filter plug 250 while also covering same in their entirety. This joined body will be referred to as a second joined body 265. The tipping paper 270 further joins the first joined body 285, the hollow tube portion 132, and the second joined body 265. Here, the tipping paper 270 covers the whole of the hollow tube portion 132 and the second joined body 265, and part of the first joined body 285, while exposing the first joined body 285 at its upstream end. The five components may be joined in a form such as shown in fig. 11. It should be noted that in fig. 11, the outer plug wrap 280 covers the flavor-generating portion 220 as far as its downstream end, but the outer plug wrap 280 may equally expose the flavor-generating portion 220 at its downstream end, without covering the flavor-generating portion 220 as far as its downstream end.

It should be noted that the form of the flavor generating article 100 is not particularly limited to the example discussed hereinabove, provided that the heating portion 40 can heat the flavor generating article 100 inserted into the flavor inhaler 200 to generate flavor. For example, the flavor generating article 100 does not need to include the tip-end plug 112.

As shown in fig. 1, when the flavor generating article 100 has been suitably inserted into the chamber 50 of the flavor inhaler 200, part of the flavor generating article 100 may be exposed to the outside of the flavor inhaler 200. Specifically, in the state shown in fig. 1, part or all of the second joined body 265 shown in fig. 9 or fig. 11 may be exposed to the outside of the flavor inhaler 200. Furthermore, in the state shown in fig. 1, part of the hollow tube portion 132 shown in fig. 9 or fig. 11 may be exposed to the outside of the flavor inhaler 200. In this case, the air flow holes vf formed in the hollow tube portion 132 may be exposed to the outside of the flavor inhaler 200, or may be positioned on the inside of the flavor inhaler 200 (upstream of the insertion opening 210 for insertion of the flavor generating article 100). The air flow holes vf formed in the hollow tube portion 132 are preferably located on the inside of the flavor inhaler 200 so that the air flow holes vf cannot easily be blocked by the user.

Fig. 12 is an oblique view of the flavor generating assembly 300. As shown in fig. 12, the flavor generating assembly 300 comprises the battery 21, the atomizing portion 30, the control portion 80, the terminal 90, the chassis 310, a bracket 320, a flexible printed circuit board (FPC) 330, and a flexible printed circuit board (FPC) 340. The FPC 330 electrically connects the terminal 90 and the circuit board 81, for example. The FPC 340 electrically connects the battery 21 and the circuit board 81, for example. This allows power to be supplied to the circuit board 81 and the heating portion 40 via the FPC 340 such that the battery 21 appropriately heats the flavor generating article 100. The flavor generating assembly 300 compactly integrates multiple parts of the flavor inhaler 200, making it possible to make the flavor inhaler 200 compact and to facilitate assembly of the flavor inhaler 200. Although there is no particular restriction to the parts of the flavor inhaler 200 that are included in the flavor generating assembly 300, the flavor generating assembly 300 preferably includes the heating portion 40 and the control portion 80, and more preferably also includes at least one of the battery 21 and the chamber 50. Since the battery 21 and the chamber 50 are components of the flavor inhaler 200 that have a relatively large volume, integrating these components into the flavor generating assembly 300 allows the flavor inhaler 200 to be made more compact.

As shown in fig. 12, the flavor generating assembly 300 has a central axis Ax2 that extends in the longitudinal direction. As can be seen from fig. 3 and fig. 12, the communication element 82 is located on the second opening portion 412 side of the central axis Ax2. This allows electromagnetic waves from the communication element 82 to pass more easily through the second opening portion 412, further reducing the risk of communication being obstructed by the case portion 400, etc.

The chassis 310 functions as a supporting body for each part of the flavor generating assembly 300. Although there is no particular restriction to the material constituting the chassis 310, the chassis 310 may comprise a resin such as PC, or a metal, for example.

The bracket 320 is configured to hold members, such as the circuit board 81, to prevent them falling out. In the illustrated example, the bracket 320 is attached to the chassis 310. Although there is no particular restriction to the material constituting the bracket 320, the bracket 320 may comprise a metal such as stainless steel. The bracket 320 may be configured to cover a portion of the circuit board 81.

In the illustrated example, the leads from the heating portion 40, the circuit board 81, and the terminal 90 are electrically connected via the FPC 330. Using the FPC 330 allows the flavor generating assembly 300 to be made light and compact. The FPC 330 can be electrically connected to any electrical or electronic components of the flavor generating assembly 300.

As shown in fig. 12, the battery 21 has a pair of battery tabs 23. The battery tabs 23 extend from the positive electrode and the negative electrode of the battery 21 respectively. The FPC 340 is electrically connected to the battery tabs 23. The heating portion 40 is disposed adjacent to the battery 21 in the longitudinal direction. The circuit board 81 is disposed adjacent to the FPC 340 in the longitudinal direction and adjacent to the heating portion 40 in a direction (X direction) perpendicular to the longitudinal direction. In this case, the flavor inhaler 200 can be made smaller since the heating portion 40 and the circuit board 81 are disposed adjacent to the battery 21 and the FPC 340 in the longitudinal direction and the FPC 340 is electrically connected to the battery tabs 23.

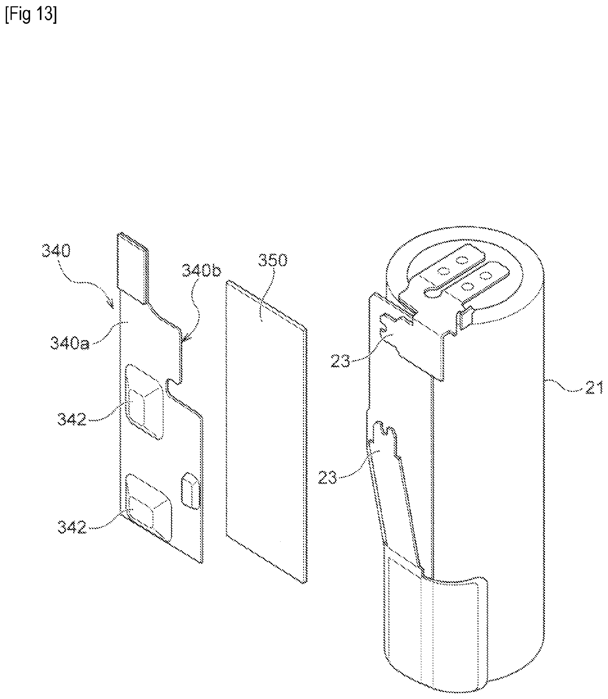

Fig. 13 is an exploded oblique view of the battery 21 and the FPC 340. As shown in fig. 13, the FPC 340 has soldering portions 342 that are soldered to the battery tabs 23. The soldering portions 342 are electrical contacts that connect to the battery tabs 23. In the illustrated example, the FPC 340 has a pair of soldering portions 342 that are soldered to a pair of battery tabs 23. As shown in fig. 12 and fig. 13, the soldering portions 342 are disposed so as to at least partially overlap the battery 21. In the illustrated example, the soldering portions 342 are disposed so as to at least partially overlap the battery 21 when viewed from a direction perpendicular to the longitudinal direction (X direction). In other words, the soldering portions 342 are disposed such so as to at least partially overlap the battery 21 when viewed from the thickness direction of the FPC 340. Now, when the battery tabs 23 and the soldering portions 342 are soldered, the heat generated by the soldering may be transferred to the battery 21. Accordingly, in the present embodiment, a first member 350 is disposed between the FPC 340 and the battery 21. The first member 350 may include a heat insulating member and/or a heat diffusing member. That is, the first member 350 may consist of a heat insulating member only, a heat diffusing member only, or a heat insulating member and a heat diffusing member. The heat insulating member and/or the heat diffusing member can inhibit the transfer of heat generated at the soldering portions 342 to the battery, or the localized transfer of this heat to the battery 21, thereby making it possible to inhibit the heat generated by soldering from adversely affecting the battery 21. In the example shown in fig. 13, the first member 350 has a sheet shape and is disposed so as to be sandwiched between the battery 21 and the FPC 340. The configuration is not limited thereto, and the first member 350 may have any shape. If the first member 350 includes a heat insulating member and a heat diffusing member, a sheet-shaped insulating member and a sheet-shaped heat diffusing member may be overlapped to form the first member 350.

If the first member 350 includes a heat insulating member, the heat insulating member may comprise nylon or Nomex. In this case, the heat insulating member can be configured using an inexpensive and readily available material. The configuration is not limited thereto, and the heat insulating member may comprise any known thermally insulating material. Furthermore, if the first member 350 includes a heat diffusing member, the heat diffusing member may comprise a graphite sheet. In this case, the heat diffusing member can be configured using an inexpensive and readily available material. The configuration is not limited thereto, and the heat diffusing member may comprise any known heat diffusion material.

Preferably, the first member 350 is disposed between the soldering portions 342 and the battery 21. The soldering portions 342 become hotter than other parts of the FPC 340 when being soldered to the battery tabs 23. Therefore, by disposing the first member 350 between the soldering portions 342 and the battery 21, the transfer of heat generated at the soldering portions 342 can be efficiently inhibited. In the example shown in fig. 12, the first member 350 may be disposed between substantially the entire FPC 340 and the battery 21. In this case, the transfer of heat generated at the soldering portions 342 can be further inhibited.

Preferably, the heat insulating member or heat diffusing member of the first member 350 is in direct or indirect contact with the FPC 340 and the battery 21. In this case, it is possible to inhibit the formation of gaps between the heat insulating member or heat diffusing member and the FPC 340 and the battery 21, thereby making it possible to inhibit deformation of the FPC 340 board as a result of the FPC 340 being pressed by the soldering iron during soldering of the battery tabs 23 and the soldering portions 342. In addition, the flavor inhaler 200 can be made compact. Specifically, if the first member 350 has only a heat insulating member or only a heat diffusing member, the heat insulating member or the heat diffusing member may be in direct contact with both the FPC 340 and the battery 21. If the first member 350 has a heat insulating member and a heat diffusing member, one of the heat insulating member or heat diffusing member may be in direct contact with the FPC 340 and the other may be in direct contact with the battery 21. In this case, it can be said that one of the heat insulating member or the heat diffusing member is in indirect contact with the battery 21, and the other is in indirect contact with the FPC 340. The first member 350 may be affixed to the surface of the FPC 340 facing the battery 21, or to the surface of the battery 21 facing the FPC 340. Furthermore, members other than the heat insulating member and the heat diffusing member may also be disposed between the FPC 340 and the battery 21.

Preferably, the first member 350 has both a heat insulating member and a heat diffusing member. In this case, the heat diffusing member is preferably disposed closer to the FPC 340 than the heat insulating member, and the heat insulating member is preferably disposed closer to the battery 21 than the heat diffusing member. As a result, heat transfer can be inhibited by means of the heat insulating member located relatively close to the soldering portions 342 of the FPC 340, and heat from the heat insulating member can be diffused by means of the heat diffusing member located relatively close to the battery 21. Therefore, the heat insulating member and the heat diffusing member can efficiently inhibit the transfer of heat generated at the soldering portions 342. Specifically, for example, a sheet-shaped heat insulating member may be disposed on the FPC 340 side and a sheet-shaped heat diffusing member may be disposed on the battery 21 side to form the first member 350.

As shown in fig. 13, the FPC 340 preferably has a first surface 340a on which the soldering portions 342 are provided and a second surface 340b facing the first member 350. If the soldering portions 342 were provided on the second surface 340b, it would be necessary to dispose the first member 350 between the FPC 340 and the battery 21 after the battery tabs 23 and the soldering portions 342 have been soldered. However, when the soldering portions 342 are provided on the first surface 340a, soldering of the soldering portions on the first surface 340a can be performed after assembly with the battery 21 such that the second surface 340b of the FPC 340 faces the first member 350. The assembly and soldering of the battery 21, the first member 350 and the FPC 340 can therefore be made easier than in a case in which the soldering portions 342 are provided on the second surface 340b.

In a state in which the FPC 340 and the battery tabs 23 are connected as shown in fig. 12, the distance between the solder portions 342 and the battery 21 may, for example, be 1.5 mm or less, and more preferably 0.9 mm or less. Thus, although heat generated during soldering is transferred readily to the battery 21 if the soldering portions 342 and the battery 21 are close to one another, the heat insulating member and/or the heat diffusing member of the first member 350 can inhibit transfer of the heat generated at the soldering portions 342 to the battery 21, or the localized transfer of this heat to the battery 21.

A method for manufacturing the flavor inhaler 200 will next be described. The manufacturing method includes a process for soldering the battery 21 and the FPC 340 shown in fig. 12 and fig. 13. Specifically, the manufacturing method includes: a first step for disposing the first member 350 between the battery 21 and the FPC 340; and a second step, after the first step, for soldering the battery tabs 23 of the battery 21 and the FPC 340 together. In this case, the first member 350 can inhibit the transfer of heat generated by the soldering in the second step to the battery 21, or the localized transfer of this heat to the battery 21, thereby making it possible to inhibit the heat generated by the soldering from adversely affecting the battery 21.

In addition, the method for manufacturing the flavor inhaler 200 may include, after the second step, a step for removing the first member 350 from between the battery 21 and the FPC 340. In this case, the first member 350 can be reused in the manufacture of other flavor inhalers 200, thereby making it possible to inhibit an increase in the manufacturing costs.

While embodiments of the present invention have been described above, the embodiments of the invention described above are for ease of understanding of the present invention and do not limit the present invention. The present invention may be modified and improved without departing from the spirit thereof, and equivalents thereof are included in the present invention. Furthermore, components described in the claims and specification may be combined or omitted within a scope that enables at least some of the problems described above to be solved, or within a scope that demonstrates at least some of the advantageous effects.

A number of aspects disclosed in the present specification are given below.
(1) A flavor inhaler comprising: a battery having a battery tab;
   a flexible printed circuit board having a soldering portion that is soldered to the battery tab and that is disposed so as to at least partially overlap the battery; and
   a heat insulating member and/or a heat diffusing member disposed between the flexible printed circuit board and the battery.
(2) The flavor inhaler according to (1), wherein the heat insulating member and/or the heat diffusing member are/is disposed between the soldering portion and the battery.
(3) The flavor inhaler according to (1) or (2), wherein
   the heat insulating member or the heat diffusing member is in direct or indirect contact with the flexible printed circuit board and the battery.
(4) The flavor inhaler according to any one of (1) to (3), including
   the heat insulating member and the heat diffusing member, wherein:
   the heat diffusing member is disposed closer to the battery than the heat insulating member; and
   the heat insulating member is disposed closer to the flexible printed circuit board than the heat diffusing member.
(5) The flavor inhaler according to any one of (1) to (4), wherein
   the flexible printed circuit board has a first surface on which the soldering portion is provided and a second surface facing the heat insulating member and/or the heat diffusing member.
(6) The flavor inhaler according to any one of (1) to (5), comprising
   a heating portion configured to heat a flavor generating article, and
   a circuit board configured to control heating of the heating portion, wherein
   the flexible printed circuit board is connected to the circuit board.
(7) The flavor inhaler according to (6), wherein:
   the heating portion is disposed adjacent to the battery in a longitudinal direction; and
   the circuit board is disposed adjacent to the flexible printed circuit board in the longitudinal direction and adjacent to the heating portion in a direction perpendicular to the longitudinal direction.
(8) The flavor inhaler according to any one of (1) to (7), wherein
   the distance between the soldering portion and the battery is 1.5 mm or less.
(9) The flavor inhaler according to any one of (1) to (8), wherein
   the heat insulating member comprises nylon or Nomex.
(10) The flavor inhaler according to any one of (1) to (9), wherein
   the heat diffusing member is a graphite sheet.
(11) A method for manufacturing a flavor inhaler, the method including: a first step for disposing a heat insulating member and/or a heat diffusing member between a battery and a flexible printed circuit board; and
   a second step, after the first step, for soldering a battery tab of the battery and the flexible printed circuit board together.
(12) The method for manufacturing a flavor inhaler according to (11), including,
   after the second step, a step for removing the heat insulating member and/or the heat diffusing member from between the battery and the flexible printed circuit board.

### REFERENCE SIGNS LIST

21: Battery
23: Battery tab
32: Heat insulating portion
40: Heating portion
81: Circuit board
100: Flavor generating article
200: Flavor inhaler
340: FPC
340a: First surface
340b: Second surface
342: Soldering portion
350: First member

## Claims

1. A flavor inhaler comprising: a battery having a battery tab;
a flexible printed circuit board having a soldering portion that is soldered to the battery tab and that is disposed so as to at least partially overlap the battery; and
a heat insulating member and/or a heat diffusing member disposed between the flexible printed circuit board and the battery.

2. The flavor inhaler as claimed in claim 1, wherein
the heat insulating member and/or the heat diffusing member are/is disposed between the soldering portion and the battery.

3. The flavor inhaler as claimed in claim 1 or 2, wherein
the heat insulating member or the heat diffusing member is in direct or indirect contact with the flexible printed circuit board and the battery.

4. The flavor inhaler as claimed in any one of claims 1 to 3, including
the heat insulating member and the heat diffusing member, wherein:
the heat diffusing member is disposed closer to the flexible printed circuit board than the heat insulating member; and
the heat insulating member is disposed closer to the battery than the heat diffusing member.

5. The flavor inhaler as claimed in any one of claims 1 to 4, wherein
the flexible printed circuit board has a first surface on which the soldering portion is provided and a second surface facing the heat insulating member and/or the heat diffusing member.

6. The flavor inhaler as claimed in any one of claims 1 to 5, comprising
a heating portion configured to heat a flavor generating article, and
a circuit board configured to control heating of the heating portion, wherein
the flexible printed circuit board is connected to the circuit board.

7. The flavor inhaler as claimed in claim 6, wherein:
the heating portion is disposed adjacent to the battery in a longitudinal direction; and
the circuit board is disposed adjacent to the flexible printed circuit board in the longitudinal direction and adjacent to the heating portion in a direction perpendicular to the longitudinal direction.

8. The flavor inhaler as claimed in any one of claims 1 to 7, wherein
the distance between the soldering portion and the battery is 1.5 mm or less.

9. The flavor inhaler as claimed in any one of claims 1 to 8, wherein
the heat insulating member comprises nylon or Nomex.

10. The flavor inhaler as claimed in any one of claims 1 to 9, wherein
the heat diffusing member is a graphite sheet.

11. A method for manufacturing a flavor inhaler, the method including: a first step for disposing a heat insulating member and/or a heat diffusing member between a battery and a flexible printed circuit board; and
a second step, after the first step, for soldering a battery tab of the battery and the flexible printed circuit board together.

12. The method for manufacturing a flavor inhaler as claimed in claim 11, including, after the second step, a step for removing the heat insulating member and/or the heat diffusing member from between the battery and the flexible printed circuit board.
